Europäisches Patentamt

European Patent Office

Office européen des brevets

(11) Publication number: **0 160 406**
**B1**

## (12) EUROPEAN PATENT SPECIFICATION

(45) Date of publication of patent specification: **20.09.89**

(21) Application number: **85302262.2**

(22) Date of filing: **01.04.85**

(51) Int. Cl.⁴: **H 01 B 1/10**

(54) **Electroconductive articles and a method of producing the same.**

(30) Priority: **06.04.84 JP 67463/84**
**09.11.84 JP 236378/84**
**09.11.84 JP 236379/84**
**18.01.85 JP 6990/85**

(43) Date of publication of application:
**06.11.85 Bulletin 85/45**

(45) Publication of the grant of the patent:
**20.09.89 Bulletin 89/38**

(84) Designated Contracting States:
**DE FR GB**

(56) References cited:
**EP-A-0 035 406**
**EP-A-0 086 072**

(73) Proprietor: **Bridgestone Corporation**
**10-1, Kyobashi 1-Chome Chuo-Ku**
**Tokyo 104 (JP)**

(72) Inventor: **Aoki, Masami**
**9-31, Fujimi-Cho 3-Chome**
**Higashimurayama City Tokyo (JP)**
Inventor: **Kitamura, Takashi**
**1-1009, 1464-1, Hazama-Cho**
**Hachioji City Tokyo (JP)**
Inventor: **Ohashi, Takashi**
**2965-5, Miyadera**
**Iruma City Saitama Prefecture (JP)**

(74) Representative: **Whalley, Kevin et al**
**MARKS & CLERK 57/60 Lincoln's Inn Fields**
**London WC2A 3LS (GB)**

**Description**

This invention relates to electroconductive articles and to a method of producing the same.

As electroconductive polymer materials, there have hitherto been known fibers and films obtained by adhering cuprous sulfide as an electroconductive layer to high molecular weight substances having a nitrile group such as acrylic fibers and acrylic films. These materials are produced by utilizing coordinate bonds of monovalent copper ions to nitrile groups as a copper dyeing process. In this case, the cuprous sulfide ($Cu_2S$) of the electroconductive layer actually has a composition $Cu_xS$ ($1.75 \leq x < 2$) slightly deviated from the stoichiometric quantity and is reported to exhibit the behaviour of a P-type semiconductor. However, the electroconductive articles having cuprous sulfide as the electroconductive layer thereof exhibit unsatisfactory electroconductivity.

On the other hand, it is known that cupric sulfide (CuS) exhibits an electroconductivity higher by at least a figure than that of cuprous sulfide ($Cu_xS$, $1.75 \leq x < 2$). However, bivalent copper ion has poor coordination ability to the functional group of the polymer material as compared with monovalent copper ion, so that it is very difficult to produce electroconductive articles containing cupric sulfide as the electroconductive layer.

EP—A—0086072 describes an electrically conducting material including a cyanic group-containing material having adsorbed thereby sulphides of copper and an auxiliary metal selected from silver, gold and elements of the platinum group. The cyanic group-containing material is in the form of powder or a shaped body such as fibre, film, plate, rod or like and is formed of a synthetic polymer such as polyacrylonitrile or a polyamide having introduced thereinto cyanic groups; a naturally occurring polymeric substance such as cotton having introduced thereinto cyanic groups; or a low molecular compound such as phthalonitrile.

EP—A—0035406 describes an electrically conducting acrylic or modacrylic fibre impregnated with 1 to 30 wt.% of copper sulfide, e.g. digenite. A two-step method of making these fibres comprises subjecting the fibres to a first heat-treatment in a bath containing a copper compound and a reducing agent to adsorb monovalent copper ions into the fibres, and subjecting the fibre to a second heat-treatment in the presence of a sulfur-containing compound to convert said adsorbed monovalent copper ions to copper sulfide. An alternative one-step method comprises subjecting the fibre to heat treatment in a bath which contains a copper ion compound, a reducing agent which is capable of reducing copper ions to monovalent ions, and a sulfur-containing compound to convert monovalent copper ions to copper sulfide.

The present inventors have made various studies with respect to electroconductive articles utilizing the electroconductivity of cupric sulfide, and have found that electroconductive articles having a high electroconductivity can be produced by treating polyurethane foam provided with cuprous sulfide as an electroconductive layer in a solution of a sulfur releasable substance to convert the greater part of the electroconductive layer into cupric sulfide without adversely affecting the adhesion performance of the electroconductive layer to the polyurethane foam.

According to the first aspect of the invention, there is provided an electroconductive article comprising a polyurethane foam substrate, and an electroconductive layer of cupric sulfide formed thereon.

According to a second aspect of the invention, there is provided a method of producing an electroconductive article, comprising immersing a polyurethane foam in an aqueous solution containing a bivalent copper compound and a reducing agent or an aqueous solution containing a monovalent copper compound, and at the same time or subsequently treating it in a solution of a sulfur releasable substance.

Suitable polyurethane foams are nitrile group-containing polyurethane foams (for example polyurethane foam containing polyol grafted with acrylonitrile).

The polyvinyl chloride containing polyurethane foams are generally known as foams of a grade having flame retardant properties and may easily be produced or are commercially available. Suitable such foams are polyurethane foams containing 2 to 100 parts by weight, preferably 5 to 40 parts by weight, of finely divided polyvinyl chloride based on 100 parts by weight of polyol, an example of which is a flexible polyurethane foam containing polyvinyl chloride, zinc oxide and antimony trioxide. When the content of polyvinyl chloride is less than 2 parts by weight, the adhesion of copper sulfide may be insufficient and it may be difficult to obtain practical electroconductivity, while when the polyvinyl chloride content exceeds 100 parts by weight, the effect of improving the electroconductivity becomes saturated and the viscosity of the mixed liquid consisting mainly of polyol increases to make good foaming difficult and also the properties of the resulting foam are degraded. This polyurethane foam can easily be produced by compounding polyvinyl chloride dispersed polyol with polyisocyanate foaming agent, catalyst, foam stabilizer amd other additives and then foaming it.

According to the invention, an electroconductive layer of a cuprous compound is first formed in the polyurethane foam by immersing the polyurethane foam in an aqueous solution containing a bivalent copper compound and a reducing agent or an aqueous solution containing a monovalent copper compound. In this case, it is preferable that the immersion treatment is carried out by gradually heating from room temperature to a temperature of 50—120°C. Moreover, the immersion time is dependent upon the concentration of the copper compound used and the treating temperature, but it is preferably about 90 minutes for obtaining good adhesion of copper compound when the polyurethane foam is immersed, for example, in an aqueous solution having a concentration of cuprous chloride of 0.4 mol/l at 60°C.

The monovalent copper compound may be suitably cuprous chloride, cuprous iodide, cuprous cyanide, or cuprous thiocyanate. The bivalent copper compound may be suitably cupric sulfate, cupric chloride, cupric nitrate, cupric acetate, or cupric oxalate. The reducing agent may be suitably metallic copper, ferrous sulfate, sodium hypophosphite, hydroxylamine or a salt thereof, ammonium vanadate, furfural, and glucose.

In case of using the monovalent copper compound, a dissolving aid such as hydrochloric acid or ammonium chloride may be added, if necessary. Moreover, in the aqueous solution containing the cupric copper compound and the reducing agent, cupric ion is reduced to cuprous ion suitably at 90—120°C at pH=1.5—4.0, whereby the resulting cuprous ion is bonded by coordination to the polyurethane foam. In order to efficiently enhance the adhesion of the cuprous compound to the polyurethane foam, it is preferred that the surface of the polyurethane foam is previously roughened by treating with an aqueous alkali solution or by removing cell membranes from the foam as the substrate according to an explosive process and then treating with the aqueous alkali solution.

The amount of the cuprous compound adhered to the polyurethane foam substrate is preferably not less than 1% by weight, more preferably not less than 3% by weight based on the weight of the substrate.

According to the invention, the thus treated polyurethane foam is treated in a solution of a sulfur releasable substance during or after the above immersion treatment, whereby a sulfurization reaction is caused to convert the cuprous compound into cupric sulfide. In this case, the concentration (by molar ratio) of sulfur in the solution is preferably not more than 3 times, more preferably not more than 2 times, the concentration of the cuprous compound. Most preferably, the molar ratio of the sulfur concentration to the cuprous ion concentration is 1:1.

The term "sulfur releasable substance" used herein means substances capable of releasing sulfur atoms and/or sulfur ions, examples of which include elemental sulfur, sodium thiosulfate, sodium sulfide, sodium hydrogensulfite, sulfurous acid, sodium dithionite, dithionous acid, Rongalit (trade name), ammonium sulfide, potassium sulfide, ammonium polysulfide, sodium polysulfide, potassium polysulfide, sulfur dioxide and hydrogen sulfide.

The solution of sulfur releasable substance may be suitably a solution of elemental sulfur in benzene, toluene, xylene, ether or alcohol. In this case, an amine for generating free sulfur from the sulfur solution, such as n-butylamine, ethanolamine, morpholine, ethylenediamine or piperidine, may be added to promote the sulfurization reaction. In the sulfur solution, the concentration of sulfur is preferably within a range of 0.5—3% by weight, and the concentration of amine is preferably within a range of 0.1—3% by weight.

In addition to the sulfur solution, an aqueous solution of the sulfur releasable substance such as ammonium sulfide, sodium sulfide, potassium sulfide, ammonium polysulfide, sodium polysulfide and potassium polysulfide may also be used. In this case, the concentration of such a sulfur releasable substance is preferably within a range of 2—20% by weight.

Furthermore, an aqueous solution obtained by blowing a sulfur-containing gas such as sulfur dioxide or hydrogen sulfide into water may be used as the solution of the sulfur releasable substance.

The sulfurization treatment with the solution of sulfur releasable substance is generally carried out at a temperature above room temperature, preferably at a temperature of 50—120°C. For example, when the treating temperature is 60°C, the treating time is suitably about 90 minutes. As the treating temperature rises, the treating time is shortened, but when the treating temperature exceeds 120°C, the strength of the resulting electroconductive article adversely lowers. Moreover, the treating time can be shortened by irradiating the solution of sulfur releasable substance with ultraviolet rays, electron radiation or γ-rays. In particular when a polyvinyl chloride containing polyurethane foam is used as the polyurethane foam, the adhesion of cupric sulfide is higher than the case of using other than the above polyurethane foam even if the sulfurization treatment is carried out at the same temperature for the same time, and the electroconductivity is generally improved.

In the electroconductive article according to the invention, the amount of cupric sulfide adhered to the polyurethane foam substrate is preferably not less than 1% by weight, more preferably 3 to 30% by weight based on the weight of the substrate. When the amount of cupric sulfide is less than 1% by weight, the desired electroconductivity may not be obtained, while when the cupric sulphide amount exceeds 30% by weight, the electroconductivity may become substantially saturated and the properties of the article such as strength and flexibility may deteriorate.

It is preferable that the cuprous compound as the electroconductive layer is completely changed into cupric sulfide by the sulfurization treatment because the electroconductivity of the resulting article is then highest. However, when at least 20% of the cuprous compound is converted into the cupric compound, the electroconductivity is at least 2 times that of an electroconductive layer composed of only the cuprous compound, which can sufficiently be put into practical use.

The electroconductive articles according to the invention may be widely used for various applications, for example wall coverings, ceilings and floor coverings in dark rooms as a radio wave absorbing material; as gaskets and the like in office supplies and OA supplies as an electromagnetic wave shielding material; as molded laminates with unsaturated polyester resin in parabolic antennae as a radio wave reflecting material; as sheet heating resistance elements and tape-like heating resistance elements as a heating resistor; as foam for the prevention of static faults as a material in the field of static electricity, as static shielding material in the field of electron materials; as conductive mats for collectors; and as electroflooring mats, sleeping mats, mattresses, and small size mats for hot compresses and the like as a material for low frequency or static treatment. In particular, when a polyvinyl chloride containing polyurethane foam is used as a polyurethane foam, the copper sulfide is absorbed by the foam in a uniformly dispersed state, so that the resulting electroconductive article has excellent electroconductivity and still retains good foam texture, and also the burning speed is notably slow as compared with a conventional article because of its flame retardant properties, which makes it suitable for use in interior parts of automobiles.

The invention will be further described with reference to the following illustrative Examples. In these examples, all percentages are by weight unless otherwise stated.

Example 1

To 100 parts by weight of polymer polyol containing 20% of acrylonitrile were added 4.4 parts by weight of water, 48.5 parts by weight of TDI-80 (trade name) and given amounts of foam stabilizer and catalyst to produce a nitrile group-containing polyurethane foam with a density of 0.025 g/cm$^3$, from which cell membranes were removed by an explosive process. The thus obtained foam was immersed in an aqueous solution of 15% of sodium hydroxide for 30 minutes, washed with water, dried, subjected to a heat treatment in an aqueous solution containing 0.1 mol/l of cupric sulfate and 0.1 mol/l of sodium thiosulfate at 60°C for 60 minutes, washed with water and dried to obtain a greyish black foam. This foam had a volume resistivity of 17.8 $\Omega \cdot$ cm. Then, the foam was immersed in an aqueous solution of 5% of ammonium polysulfide at 60°C for 20 minutes, washed with water and dried to obtain a black foam. The latter foam has a volume resistivity of 2.72 $\Omega \cdot$ cm.

Examples 2 and 3

To 100 parts by weight of polymer polyol containing 20% of acrylonitrile were added 4.4 parts by weight of water, 48.5 parts by weight of TDI-80 and given amounts of foam stabilizer and catalyst to form a foam with a density of 0.0250 g/cm$^3$, from which cell membranes were removed by an explosive process.

The resulting foam was immersed in an aqueous solution containing 15% by weight of sodium hydroxide for 60 minutes, washed with water, dried and again immersed in a solution of 39.6 g of cuprous chloride and 8 g of hydrochloric acid in 1 l of water at 60°C for 90 minutes (Example 2) or 120 minutes (Example 3). Thereafter, the foam was lightly washed with water, immersed in an aqueous solution of 5% by weight of ammonium polysulfide at 60°C for 30 minutes, washed with water and dried. The thus obtained foam turned deep blackish green and had surface resistance ($\rho s$) and volume resistivity ($\rho v$) as shown in the following Table 1. As a result of measurement by X-ray diffraction, diffraction peaks corresponding to CuS appeared at 2θ of 29.2°, 31.7° and 47.8° in all samples. Moreover, the adhesion rate (% by weight) of CuS is shown in Table 1.

TABLE 1

| Example | Immersing time in CuCl$_2$ (min.) | Adhesion rate (wt.%) | $\rho s$ ($\Omega$) | $\rho v$ ($\Omega \cdot$ cm) |
|---|---|---|---|---|
| 2 | 90 | 6.9 | $1.1 \times 10^2$ | $1.5 \times 10^2$ |
| 3 | 120 | 7.7 | 8.5 | $1.1 \times 10$ |

Comparative Example 1

The same foam as used in Example 2 was immersed in an aqueous solution of 15% by weight of sodium hydroxide for 60 minutes, washed with water, dried and immersed in an aqueous solution containing 39.6 g/l of cuprous chloride, 8 g/l of hydrochloric acid and 5% by weight of ammonium polysulfide at 60°C for 60 minutes. Then, the thus treated foam was washed with water and dried to obtain a foam having a substantially unchanged color, surface resistance and volume resistivity of not less than 10$^7$ and no diffraction peak of CuS as measured from X-ray diffraction.

On the other hand, blackish green powder produced in the reaction liquid showed diffraction peaks corresponding to CuS as measured from X-ray diffraction.

It is understood from the above that CuS is produced by one-step process but does not adhere to the surface of the foam.

Example 4

A flexible ether-series polyurethane foam with a size of 10 cm×10 cm×1 cm, whose cell membranes were removed by an explosive process, was immersed in an aqueous solution of 15% by weight of sodium hydroxide for 1 hour, washed with water, immersed in 500 cc of an aqueous solution of 0.10 mol/l of cupric sulfate at 60°C for 60 minutes and then held in the same solution further containing 500 cc of an aqueous solution of 0.10 mol/l of sodium thiosulfate at 60°C for 60 minutes. The thus treated foam was washed with water and dried to obtain a blackish brown foam having a volume resistivity of $7.6\times10^2$ $\Omega\cdot$cm.

Then, this foam was immersed in an aqueous solution of 5% by weight of ammonium polysulfide at 60°C for 30 minutes, washed with water and dried to obtain a blackish green foam having a volume resistivity of $1.7\times10^2$ $\Omega\cdot$cm. This shows that the electroconductivity is improved by the sulfurization treatment.

As a result of measurement by X-ray diffraction, the foam before the treatment with ammonium polysulfide showed diffractin peaks corresonding to $Cu_{1.8}S$ at 2 θ of 46.3°, 32.1° and 27.7°, while the foam after the treatment with ammonium polysulfide showed diffraction peaks at 2θ of 47.8°, 31.7° and 29.2°, which corresponded to CuS.

Example 5

An open-cell, flexible ester series polyurethane foam was treated by the same procedure as described in Example 4.

As a result, the foam after the treatment with cupric sulfate and sodium thiosulfate was blackish brown and had a volume resistivity of not less than $10^7$ $\Omega\cdot$cm, while the foam after the treatment with ammonium polysulfide turned blackish green and had a volume resistivity of $2.4\times10^2$ $\Omega\cdot$cm. Further, the latter foam clearly showed diffraction peaks of CuS as measured from X-ray diffraction.

Example 6

The same flexible ester series polyurethane foam as used in Example 5 was treated by the same procedure as described in Example 4, except that the foam was first immersed in an aqueous solution containing 0.10 mol/l of cupric sulfate and 0.10 mol/l of sodium thiosulfate while gradually warming from room temperature to 60°C and holding at 60°C for 60 minutes. The foam after the treatment with cupric sulfate and sodium thiosulfate was blackish brown and had a volume resistivity of not less than $10^7$ $\Omega\cdot$cm, while the foam after the treatment with ammonium polysulfide turned blackish green and had a volume resistivity of $9.6\times10$ $\Omega\cdot$cm.

Example 7

A flexible polyurethane foam with a density of 0.028 g/cm³ was prepared by adding 15 parts by weight of polyvinyl chloride to 100 parts by weight of polyol and then foaming it in the usual manner, from which a sample foam having a size of 10 cm×10 cm×1 cm was cut out. The sample foam was immersed in a solution of 25 g of cupric sulfate in 1,500 g of water at 60°C for 60 minutes, and then a solution of 223 g of sodium thiosulfate in 500 g of water was added at 60°C, in which was further immersed the foam for 90 minutes. Thereafter, the foam was taken out from the solution, washed with water and dried to obtain a deep blackish green foam. In the latter foam, the increment of weight was 11.2% and the volume resistivity was as low as 1.19 $\Omega\cdot$cm. As a result of measurement by X-ray diffraction, peaks corresponding to CuS appeared at 2 θ of 29.2°, 31.7° and 47.8° (X-ray used: CuKα).

Example 8

A flexible polyurethane foam having a density of 0.0200 g/cm³ (hereinafter referred to as foam A) was prepared by adding 15 parts by weight of polyvinyl chloride to 100 parts by weight of polyol and then foaming in usual manner. This foam was immersed in a solution of 25 g of cupric sulfate and 199 g of sodium thiosulfate in 2,000 g of water, while gradually warming from room temperature to 60°C, for 150 minutes. After the immersion treatment, the foam A was washed with water and dried to obtain a deep blackish green foam A. The foam A had an increment of weight of 6.74% and a volume resistivity of $2.05\times10^{-2}$ $\Omega\cdot$cm and showed peaks corresponding to CuS as measured from X-ray diffraction.

Moreover, the electroconductive foam A was subjected to a burning test according to a method of MVSS No. 302. As a result, the burning rate was 87 mm/min, which showed that the polyvinyl chloride containing polyurethane foam after the sulfurization treatment had excellent flame retardant property.

Example 9

The same foam A as used in Example 8 was immersed in a solution of 125 g of cupric sulfate in 500 g of water at 60°C for 60 minutes. Then, a solution of 112 g of sodium thiosulfate in 500 g of water was added to the above solution at 60°C, and the foam was further immersed therein for 90 minutes. Thereafter, the foam was washed with water and dried to obtain a blackish green foam having an adhesion rate (increment of weight) of 9.04% and a volume resistivity of 3.3 $\Omega\cdot$cm. Furthermore, the foam showed peaks corresponding to CuS as measured from X-ray diffraction.

Example 10

The same foam A as used in Example 8 (size: 10 cm×10 cm×1 cm) was immersed in a solution of 79.2 g of cuprous chloride and 32 g of hydrochloric acid in 2,000 g of water at 60°C for 120 minutes, lightly washed with water, dehydrated, immersed in an aqueous solution of 5% by weight of ammonium polysulfide at 60°C for 30 minutes, washed with water, and dried to obtain a blackish green foam. This foam had an adhesion rate (increment of weight) of 10.1% and a volume resistivity of $7.3\times10^3$ $\Omega \cdot$ cm and showed peaks corresponding to CuS as measured from X-ray diffraction.

As previously mentioned in detail, according to the invention, the cuprous compound adhered to the polyurethane foam can directly be changed into cupric sulfide by sulfuzation reaction with the solution of sulfur releasable substance. That is, according to the invention, the polyurethane foam is immersed in an aqueous solution containing a bivalent copper compound and a reducing agent or an aqueous solution containing a monovalent copper compound and at the same time or subsequently treated in a solution of sulfur releasable substance, so that the electroconductive articles comprising cupric sulfide as an electroconductive layer can be efficiently produced with a high adhesion rate. Further, the number of treating steps can be reduced as compared with the prior art, and also the amount of the treating waste liquid can be made small, so that the invention has considerable advantages in industry. Moreover, the electroconductive articles according to the invention have excellent characteristics, so that they are very useful for wide applications.

## Claims

1. An electroconductive article characterized by comprising a polyurethane foam substrate, and an electroconductive layer of cupric sulfide adhered to said substrate.

2. An electroconductive article as claimed in Claim 1, characterized in that the amount of cupric sulfide adhered to the said polyurethane foam substrate is not less than 1% by weight based on the weight of the substrate.

3. An electroconductive article as claimed in Claim 2, characterized in that the amount of cupric sulfide adhered to the said polyurethane foam substrate is 3 to 30% by weight based on the weight of the substrate.

4. A method of producing an electroconductive article, characterized by immersing a polyurethane foam in an aqueous solution containing a bivalent copper compound and a reducing agent or an aqueous solution containing a monovalent copper compound, and at the same time or subsequently treating it in a solution of a sulfur releasable substance.

5. A method as claimed in Claim 4, characterized in that the said bivalent copper compound is selected from cupric sulfate, cupric chloride, cupric nitrate, cupric acetate and cupric oxalate.

6. A method as claimed in Claim 4 or 5, characterized in that the said reducing agent is selected from metallic copper, ferrous sulfate, sodium hypophosphite, hydroxylamine or a salt thereof, ammonium vanadate, furfural and glucose.

7. A method as claimed in Claim 4, characterized in that the said monovalent copper compound is selected from cuprous chloride, cuprous iodide, cuprous cyanide and cuprous thiocyanate.

8. A method as claimed in any of Claims 4 to 7, characterized in that the amount of cuprous compound adhered to the said polyurethane foam is not less than 1% by weight based on the weight of the foam.

9. A method as claimed in any of Claims 4 to 8, characterized in that the said sulfur releasable substance is selected from elemental sulfur, sodium thiosulfate, sodium sulfide, sodium hydrogensulfite, sulfurous acid, sodium dithionite, dithionous acid, ammonium sulfide, potassium sulfide, ammonium polysulfide, sodium polysulfide, potassium polysulfide, sulfur dioxide and hydrogen sulfide.

10. A method as claimed in any of Claims 4 to 9, characterized in that the concentration by molar ratio of sulfur in the said solution of sulfur releasable substance is not more than 3 times the concentration of cuprous compound in the immersion solution.

## Patentansprüche

1. Elektrisch leitender Gegenstand, gekennzeichnet, durch ein Substrat aus Polyurethane-Schaumstoff und darauf einer elektrisch leitenden Schicht aus Kupfer-II-Sulfid.

2. Elektrisch leitender Gegenstand nach Anspruch 1, dadurch gekennzeichnet, daß die Menge an Kupfer-II-Sulfid auf dem Substrat aus Polyurethan-Schaumstoff nicht weniger als 1 Gew.-%—bezogen auf das Gewicht des Substrats—beträgt.

3. Elektrisch leitender Gegenstand nach Anspruch 2, dadurch gekennzeichnet, daß die Menge an Kupfer-II-Sulfid auf dem Substrat aus Polyurethan-Schaumstoff 3 bis 30 Gew.-%—bezogen auf das Gewicht des Substrats-beträgt.

4. Verfahren zur Herstellung eines elektrisch leitenden Gegenstands, dadurch gekennzeichnet, daß man einen Polyurethan-Schaumstoff in eine wässrige Lösung, enthaltend eine Kupfer-II-Verbindung und ein Reduktionsmittel, oder eine wässrige Lösung, enthaltend eine Kupfer-I-Verbindung, eintaucht und gleichzeitig oder anschließend mit einer Lösung behandelt, die eine Schwefel freisetzende Substanz enthält.

5. Verfahren nach Anspruch 4, dadurch gekennzeichnet, daß die Kupfer-II-Verbindung das Sulfat, Chlorid, Nitrat, Acetat oder Oxalat ist.

6. Verfahren nach Anspruch 4 oder 5, dadurch gekennzeichnet, daß das Reduktionsmittel metallisches Kupfer, Eisen-II-sulfat, Natriumhypophosphit, Hydroxylamin oder dessen Salz, Ammoniumvanadat, Furfurol und Glucose sein kann.

7. Verfahren nach Anspruch 4, dadurch gekennzeichnet, daß die einwertige Kupferverbindung das Chlorid, Jodid, Cyanid oder Rhodanid ist.

8. Verfahren nach einem der Ansprüche 4 bis 7, dadurch gekennzeichnet, daß die Menge an Kupfer-I-Verbindung auf dem Polyurethan-Schaumstoff nicht weniger als 1 Gew.-%—bezogen auf das Gewicht des Schaumstoffs—beträgt.

9. Verfahren nach einem der Ansprüche 4 bis 8, dadurch gekennzeichnet, daß die Schwefel freisetzende Substanz Schwefel, Natriumthiosulfat, natriumsulfid, Natriumhydrogensulfit, schwefelige Säure, Natriumdithionit, Dithionsäure, Ammoniumsulfid, Kaliumsulfid, Ammoniumpolysulfid, Natriumpolysulfid, Kaliumpolysulfid, Schwefeldioxid oder Schwefelwasserstoff ist.

10. Verfahren nach einem der Ansprüche 4 bis 9, dadurch gekennzeichnet, daß die molare Konzentration des Schwefels in der Lösung der Schwefel freisetzenden Substanz nicht mehr als das 3-fache der Konzentration der Kupfer-I-Verbindung in der Imprägnierlösung ist.

## Revendications

1. Article électroconducteur caractérisé en ce qu'il comprend un substrat en mousse de polyuréthane et une couche électroconductrice en sulture cuivrique adhérent audit substrat.

2. Article électroconducteur selon la revendication 1, caractérisé en ce que la quantité de sulfure cuivrique adhérant audit substrat en mousse de polyuréthane n'est pas inférieure à 1% en poids calculée sur le poids du substrat.

3. Article électroconducteur selon la revendication 2, caractérisé en ce que la quantité de sulfure cuivrique adhérant audit substrat de mousse de polyuréthane est de 3 à 30% en poids calculée sur le poids du substrat.

4. Procédé d'obtention d'un article électroconducteur caractérisé en ce qu'il consiste à immerger une mousse de polyuréthane dans une solution aqueuse contenant un composé de cuivre bivalent et un agent réducteur ou une solution aqueuse contenant un composé de cuivre monovalent et à la traiter en même temps ou subséquemment dans une solution d'une substance susceptible de libérer du soufre.

5. Procédé selon la revendication 4, caractérisé en ce que le composé de cuivre bivalent est choisi parmi le sulfate cuivrique, le chlorure cuivrique, le nitrate cuivrique, l'acétate cuivrique et l'oxalate cuivrique.

6. Procédé selon l'une des revendications 4 ou 5, caractérisé en ce que l'agent réducteur est choisi parmi le cuivre métallique, le sulfate ferreux, l'hypophosphite de sodium l'hydroxylamine ou un sel de celle-ci, le vanadate d'ammonium, le furfural et le glucose.

7. Procédé selon la revendication 4, caractérisé en ce que le composé de cuivre monovalent est choisi parmi le chlorure cuivreux, l'iodure cuivreux, le cyanure cuivreux et le thiocyanate cuivreux.

8. Procédé selon l'une quelconque des revendications 4 à 7, caractérisé en ce que la quantité de composé cuivreux adhérant à ladite mousse de polyuréthane n'est pas inférieure à 1% en poids calculée sur le poids de la mousse.

9. Procédé l'une quelconque des revendications 4 à 8, caractérisé en ce que la substance susceptible de libérer du soufre est choisi parmi le soufre élémentaire, le thiosulfate de sodium, le sulfure de sodium, l'hydrogénosulfure de sodium, l'acide sulfureux, le dithionite de sodium, l'acide dithioneux, le sulfure d'ammonium, le sulfure de potassium, le polysulfure d'ammonium, le polysulfure de sodium, le polysulfure de potassium, le dioxyde de soufre et l'hydrogène sulfuré.

10. Procédé selon l'une quelconque des revendications 4 à 9, caractérisé en ce que la concentration du rapport molaire de soufre dans ladite solution de la substance susceptible de libérer du soufre n'est pas supérieure à trois fois la concentration du composé cuivreux dans la solution d'immersion.